## Europäisches Patentamt
## European Patent Office
## Office européen des brevets

(19)

(11) Veröffentlichungsnummer: **0 083 714**
**B1**

(12) **EUROPÄISCHE PATENTSCHRIFT**

(45) Veröffentlichungstag der Patentschrift:
**09.08.89**

(51) Int. Cl.⁴: **H 03 F 3/217**

(21) Anmeldenummer: **82110757.0**

(22) Anmeldetag: **22.11.82**

(54) **Schaltverstärker.**

(30) Priorität: **11.01.82 CH 116/82**

(43) Veröffentlichungstag der Anmeldung:
**20.07.83 Patentblatt 83/29**

(45) Bekanntmachung des Hinweises auf die Patenterteilung: **09.08.89 Patentblatt 89/32**

(84) Benannte Vertragsstaaten:
**BE CH DE FR GB LI**

(56) Entgegenhaltungen:
**EP–A– 0 025 234**
**DE–A– 2 935 445**
**DE–A– 3 044 956**
**US–A– 3 098 200**
**ELECTRONIQUE INDUSTRIELLE, Nr. 22, 15. Oktober 1981, Seiten 37-39, Paris, FR, L. PIERRE:"Sorties de puissance pour amplificateurs opérationnels"**

(73) Patentinhaber: **BBC Brown Boveri AG**
**Haselstrasse**
**CH-5401 Baden (CH)**

(72) Erfinder: **Furrer, Andreas**
**Neumättlistrasse 516**
**CH-5300 Turgi (CH)**
Erfinder: **Milavec, Johann**
**Wiesenweg 5**
**CH-5200 Windisch (CH)**

## Beschreibung

Die vorliegende Erfindung betrifft einen Schaltverstärker gemäss dem Oberbegriff des Patentanspruchs. Ein solcher Schaltverstärker ist z.B. aus der DE-OS 29 35 445 bekannt.

Schaltverstärker der beschriebenen Art weisen den hohen Wirkungsgrad der Klasse-D-Verstärker auf und ermöglichen wegen der galvanischen Trennung der Sekundär- von der Primärwicklung in den Schaltstufen und wegen der Serieschaltung der Ausgänge der Schaltstufen Ausgangssignale mit sehr hoher Spannung und grosser Leistung zu erzeugen. Beispielsweise ist in der DE-OS 29 35 445 ein Schaltverstärker beschrieben, der als Modulationsverstärker für einen Rundfunksender mit einer Ausgangsleistung im Bereich von 250 kW vorgesehen ist.

Wegen der Sättigung des Uebertragers ist das zulässige Tastverhältnis jeder Schaltstufe höchstens 1:1 entsprechend einer Aussteuerung von 50 %. Bei dem beschriebenen Schaltverstärker bilden darum je zwei Schaltstufen einen Verstärkerkanal, in dem die Schaltelemente und Uebertrager der Schaltstufen alternierend geschaltet bzw. erregt werden, was eine 100 %-ige Aussteuerung des Verstärkerkanals ermöglicht. Dazu wird das analoge Eingangssignal in mindestens ein Impulsfolgenpaar gewandelt, dessen beide Impulsfolgen aus dauermodulierten Impulsen bestehen und um 180° phasenverschoben sind, und jede Schaltstufe wird mit einer dieser Impulsfolgen gesteuert. Bei Schaltverstärkern mit einer Mehrzahl von Verstärkerkanälen können einander entsprechende Schaltstufen parallel angesteuert werden, oder es können eine Mehrzahl gegeneinander phasenverschobener Impulsfolgenpaare erzeugt werden, und die Schaltverstärker jedes Kanals mit einem zugeordneten Impulsfolgenpaar gesteuert werden. Es versteht sich, dass bei der beschriebenen Betriebsweise die Schaltelemente und die Uebertrager jeder Schaltstufe während jeder Periode der Impulsfolge einmal ausgeschaltet bzw. erregt werden, wobei unabhängig von der Einschalt- bzw. Erregerdauer Schaltverluste erzeugt werden.

Um diese Schaltverluste zu verringern, ist auch schon ein Schaltverstärker vorgeschlagen worden, dessen Signalwandler in vorgegebenen zeitlichen Abständen eine dem Momentanwert der Amplitude des Analogsignals entsprechende Anzahl Impulsfolgepaare erzeugt. Die beiden Impulsfolgen jedes Impulsfolgepaares sind ebenfalls um 180° phasenverschoben und bestehen aus Impulsen mit konstanter Dauer und mit einem Taktverhältnis entsprechend 1:1. Durch die Verwendung von Impulsen maximaler Dauer und der « Modulation » der Anzahl der Impulsfolgepaare kann die Anzahl der während jeder Periode der Impulsfolgen erforderlichen Schaltungen bzw. Erregungen der Uebertrager auf einen Minimalwert begrenzt und können die Schaltverluste entsprechend verringert werden.

Für die beiden beschriebenen Schaltverstärker gilt, dass die Anzahl der erforderlichen Verstärkerkanäle einerseits durch die vorgegebene maximale Ausgangsspannung und -leistung und andererseits durch die zulässige Speisespannung gegeben ist. Für den Bau von Schaltverstärkern mit hoher Ausgangsspannung und grosser Ausgangsleistung ist darum ein relativ grosser materieller Aufwand erforderlich, der praktisch verdoppelt wird, weil jeder Verstärkerkanal zwei Schaltstufen enthält.

Zum einschlägigen Stand der Technik wird zusätzlich auf die Zeitschrift Electronique Industrielle, Nr. 22/15-10-81, S. 37-39, verwiesen, aus der eine als Mittelpunktschaltung ausgebildete Gegentaktschaltung für eine Leistungsendstufe bekannt ist. Auf der Sekundärseite des Uebertragers werden hochtransformierte Impulse mittels einer Brückenschaltung gleichgerichtet und an den Ausgang der Endstufe gegeben. Dabei wird die Gegentaktschaltung ohne galvanische Trennung auf der Ansteuerseite betrieben, was für eine Spannungssummation in einer Reihenschaltung mehrerer Schaltstufen ungeeignet ist.

Auch ist es aus der DE-OS 30 44 956 bekannt, einen Schaltverstärker so auszubilden, dass nach Massgabe eines analogen Eingangssignals eine bestimmte Anzahl von Gleichspannungsquellen durch entsprechende Schalter in Serie geschaltet werden. Da hierbei die Schalter jedoch für die volle ausgangsseitige Leistung ausgelegt sein müssen, erfordert diese Lösung hochbelastbare Schaltelemente.

Der vorliegenden Erfindung liegt darum die Aufgabe zugrunde, einen Schaltverstärker zu schaffen, der bei einem vergleichsweise geringen Materialaufwand praktisch die gleichen Kennwerte wie die bisher bekannten Schaltverstärker aufweist.

Die Aufgabe wird bei einem Schaltverstärker der eingangs genannten Art durch die Merkmale aus dem Kennzeichen des Patentanspruchs gelöst.

Die Gegentaktschaltung ermöglicht, die Primärwicklung des Uebertragers während aufeinanderfolgenden Halbperioden bis zu 100 % auszusteuern, und damit den Uebertrager in der Vorwärts- und der Rückwärtsrichtung mit Leistung zu beaufschlagen. Der Zweiweggleichrichter ermöglicht weiter, die während der beiden Halbperioden in der Sekundärwicklung induzierte Spannung bzw. den entsprechenden Strom an die Serieschaltung weiterzuleiten. Damit kann eine einzelne Schaltstufe die Funktion der in den bisher gebräuchlichen Verstärkerstufen verwendeten zwei Schaltstufen übernehmen, was zur Folge hat, dass die Anzahl der für eine vorgegebene maximale Ausgangsspannung und -leistung erforderlichen Schaltstufen und damit insbesondere die Anzahl der Uebertrager auf die Hälfte verringert werden kann. Darüberhinaus sind wegen der speziellen Ausgestaltung des Signalwandlers ausgangsseitig keine Schaltelemente notwendig.

Die Gegentaktschaltung kann einfacherweise als Mittelpunktschaltung mit zwei alternierend erregbaren Schaltelementen ausgebildet sein, oder als Brückenschaltung mit zwei Paaren zusammenwirkenden Schaltelementen, welche Schaltelementpaare für die Stromleitung durch den Uebertrager in entgegengesetzten Richtungen vorgesehen sind und wovon die in der gleichen Richtung leitfähigen Schaltelemente jedes Paares alternierend erregt werden.

Der Zweiweggleichrichter kann als Zweipulsmittelpunktschaltung oder als Brückengleichrichter ausgebildet sein.

Nachfolgend werden einige bevorzugte Ausbildungsformen des neuen Schaltverstärkers mit Hilfe der Figuren beschrieben. Es zeigen :

Fig. 1 das Prinzipschema eines Schaltverstärkers mit mehreren Schaltstufenkanälen,

Fig. 2 und 3 die Blockschaltbilder verschiedener Ausführungsformen von Schaltstufen mit einer eingangsseitigen Gegentaktschaltung und einem ausgangsseitigen Zweiweggleichrichter.

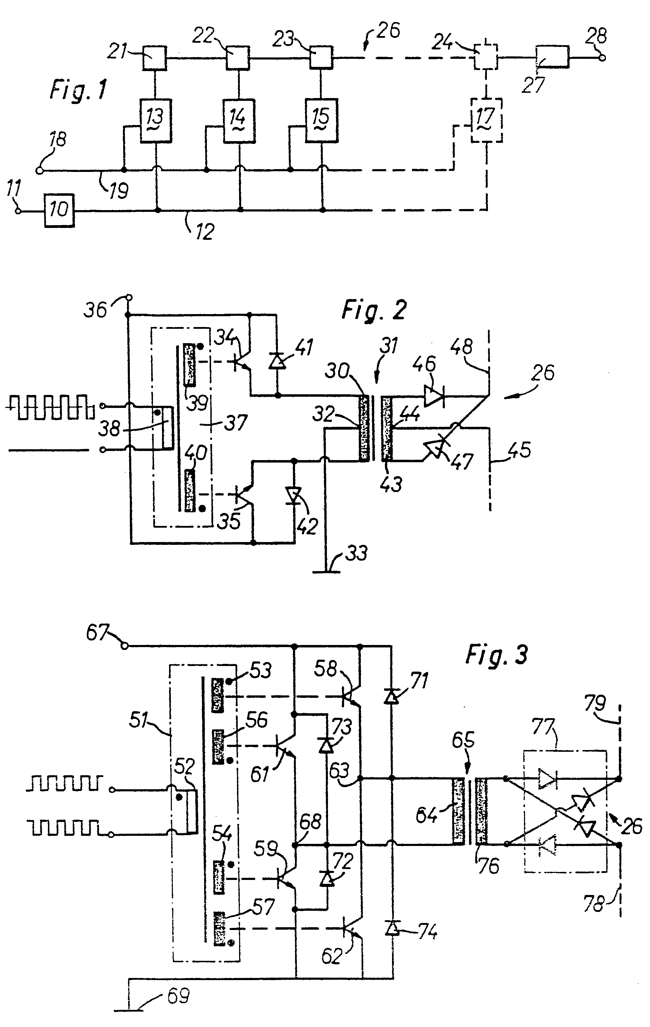

In Fig. 1 is der prinzipielle Aufbau eines Schaltverstärkers mit mehreren Schaltstufen gezeigt. Der Schaltverstärker enthält einen Signalwandler 10, dessen Eingang mit der Signaleingangsklemme 11 des Verstärkers und dessen Ausgang mittels einer Leitung 12 mit den Steuersignaleingängen einer Mehrzahl Schaltstufen 13, 14, 15, 17 verbunden ist. Weiter enthält der Schaltverstärker eine Speisespannungsklemme 18 und eine verzweigte Leitung 19, die diese Klemme mit Speisespannungseingängen 36 der Schaltstufen verbindet vgl. Fig. 2. Jede Schaltstufe enthält einen Uebertrager 31, dessen Primärwicklung 30 über mindestens ein steuerbares Schaltelement mit dem Speisespannungseingang 36 verbindbar und galvanisch von der Sekundärwicklung 43 getrennt ist. Der Ausgang jeder Schaltstufe ist mit einer Gleichrichteranordnung 21, 22, 23, 24 verbunden. Diese Anordnungen bilden eine Serieschaltung 26, die an den Eingang eines Tiefpassfilters 27 angeschlossen ist. Der Ausgang dieses Filters ist mit der Signalausgangsklemme 28 des Schaltverstärkers verbunden.

Zum Betrieb dieses Schaltverstärkers wird die Speisespannungsklemme 18 mit einer Gleichstromquelle verbunden und das zu verstärkende Analogsignal an die Signaleingangsklemme 11 geführt. Das Analogsignal wird dann im Signalwandler 10 in mindestens eine Impulsfolge gewandelt, deren Impulse die Schaltelemente in den Schaltstufen 13, 14, 15, 17 steuern. Dabei fliesst während der Dauer jedes Impulses ein Stromstoss durch die Primärwicklung 30 des Uebertragers 31. Die dabei in der Sekundärwicklung 43 jeder Schaltstufe induzierte Spannung bzw. der entsprechende Strom werden über den nachgeschalteten Gleichrichter 21, 22, 23, 24 an die Serieschaltung 26 abgegeben, in der gleichzeitig erscheinende oder teilweise überlagerte Spannungsstösse addiert werden. Das der Summe der addierten Spannungsstösse entsprechende Signal am Ende der Serieschaltung 26 wird im Tiefpassfilter 27 geglättet oder erscheint dann als verstärktes Analogsignal an der Ausgangsklemme 28.

In der bereits genannten DE-OS 29 35 445 ist eine erprobte Ausführungsform der bekannten Schaltverstärker und sind Ausführungsbeispiele für den Signalwandler 10, die Schaltstufen 13... 17 und das Tiefpassfilter 27 ausführlich beschrieben und gezeigt, weshalb auf eine detaillierte Beschreibung dieser Baugruppen hier verzichtet wird.

Die Fig. 2 zeigt eine einfache Ausführungsform einer Schaltstufe, bei der die Primärwicklung 30 des Uebertragers 31 mit den Schaltelementen 34, 35 eine Gegentaktmittelpunktschaltung bildet und der Ausgang der Sekundärwicklung 43 mit einer Zweipulsmittelpunktschaltung verbunden ist. Dazu weist die Primärwicklung 30 des Uebertragers 31 einen Mittelabgriff 32 auf, der mit einer Masseleitung 33 des Verstärkers oder der negativen Klemme der Speisespannungsquelle verbunden ist. Die beiden Enden der Primärwicklung 30 sind mit dem Emitter eines zugeordneten Schalttransistors 34 bzw. 35 verbunden. Die Kollektoren dieser Schalttransistoren sind an den Speisespannungseingang 36 angeschlossen. Weiter ist ein Steuertransformator 37 vorgesehen, dessen Primärwicklung 38 mit der Steuersignalleitung verbunden ist und dessen galvanisch getrennte Sekundärwicklungen 39, 40, die Schaltsignale für die Schaltt Transistoren 34 bzw. 35 liefern. Jedem Schalttransistor ist eine in Gegenrichtung gepolte Schutzdiode 41 bzw. 42 zugeordnet.

Die Sekundärwicklung 43 des Uebertragers weist ebenfalls einen Mittelabgriff 44 auf, der mit einem Zweig 45 der Serieschaltung 26 verbunden ist. Jedes der beiden Enden der Sekundärwicklung ist über eine Diode 46, 47 mit dem anderen Zweig 48 der Serieschaltung verbunden.

Zur Beschreibung der Arbeitsweise dieser Schaltstufe sei angenommen, dass von dem Signalwandler (10) auf der einen Steuersignalleitung zweiseitige Steuerimpulse an die Primärwicklung 38 des Steuertransformators 37 geleitet werden und die andere Leitung mit der Gerätemasse verbunden ist. Die Wicklungen des Steuertransformators sind derart angeordnet, dass bei einem positiven Signalimpuls an der Primärwicklung an der Sekundärwicklung 39 ein positiver und an der Sekundärwicklung 40 ein negativer Schaltimpuls entnommen werden kann. Bei einem positiven Signalimpuls wird dann der Transistor 34 in den leitfähigen Zustand geschaltet und der Transistor 35 gesperrt. Es fliesst ein Strom vom Speisespannungseingang 36 durch den in Figur 2 oberen Teil der Primärwicklung 30 des Uebertragers 31 zum Mittelabgriff 32 und von dort zur Masseleitung 33. Beim nachfolgenden negativen Steuerimpuls wird der Transistor 34 gesperrt und der Transistor 35 in den leitfähigen Zustand geschaltet. Dann fliesst Strom vom Speisespannungseingang 36 durch den Transistor 35 und den in der Figur 2 unteren Teil der Primärwicklung des Uebertragers 31 zum Mittelabgriff 32 und von dort zur Masseleitung 33. Der während jeder Stromflussperiode durch einen Teil der Primärwicklung 30 im entsprechenden Teil der Sekundärwicklung 32 induzierte positive Spannungs- und entsprechende Stromstoss wird über einen der Gleichrichter 46 bzw. 47 an den anderen Teil 48 der Serieschaltung 26 abgeleitet.

Die beim Unterbrechen des Stroms durch den einen Teil der Primärwicklung 30 des Uebertragers 31 im anderen Teil dieser Primärwicklung induzierten Spannungsspitzen werden durch die Dioden 41 bzw. 42 abgeleitet.

Bei der in Fig. 3 gezeigten Ausführungsform einer Schaltstufe ist die Primärwicklung 64 des Uebertragers 65 mit den zugeordneten Schaltelementen 58, 59, 61, 62 zu einer Gegentaktbrückenschaltung verbunden, und die Sekundärwicklung 76 des Uebertragers 65 ist über eine Gleichrichterbrücke 77 an die Serieschaltung 26 angeschlossen. Der Steuertransformator 51 dieser Schaltstufe weist eine Primärwicklung 52 auf, deren Enden mit der Signalleitung (12) verbunden sind, sowie vier paarweise einander zugeordnete Sekundärwicklungen 53, 54 und 56, 57, die alle galvanisch voneinander getrennt sind. Die Schaltimpulsausgänge der einander zugeordneten Sekundärwicklungen 53, 54 bzw. 56, 57 sind mit den Steuerelektroden paarweise zusammenwirkender Schalttransistoren 58, 59 bzw. 61, 62 verbunden. Das eine Schalttransistorenpaar 58, 59 ist für eine stromleitende Verbindung des einen Anschlusses 63 der Primärwicklung 64 des Uebertragers 65 mit dem Speisespannungseingang 67 und des anderen Anschlusses 68 der Primärwicklung mit der Gerätemasse 69, das andere Schalttransistorenpaar 61, 62 für eine stromleitende Verbindung des anderen Anschlusses 68 der Primärwicklung 64 mit dem Speisespannungseingang 67 und des einen Anschlusses 63 mit der Gerätemasse 69 vorgesehen. Jedem Schalttransistor 58, 59, 61, 62 ist eine Schutzdiode 71, 72, 73 bzw. 74 antiparallel geschaltet.

Die Sekundärwicklung 76 des Uebertragers ist über einen Brückengleichrichter 77 mit den Zweigen 78, 79 der Serieschaltung (26) verbunden.

Zum Beschreiben der Arbeitsweise dieser Schaltstufe sei angenommen, dass an die beiden Anschlüsse der Primärwicklung 52 des Steuertransformators 51 einseitige, um 180° phasenverschobene Steuerimpulse geleitet werden, und dass die Wicklungen derart angeordnet sind, dass von jedem an die Primärwicklung geleiteten Signalimpuls in jeder der paarweise einander zugeordneten Sekudärwicklungen ein Schaltimpuls gleicher Polarität und in jedem Sekundärwicklungspaar Schaltimpulse entgegengesetzter Polarität erzeugt werden. Dann erscheint während der Dauer eines positiven Impulses auf der in der Figur 3 oberen Leitung zur Primärwicklung 52 des Steuertransformators 51 ein positiver Schaltimpuls an den Eingängen der einander zugeordneten Sekundärwicklungen 53, 54 und ein negativer Schaltimpuls an den ebenfalls einander zugeordneten Sekundärwicklungen 56, 57. Diese Schaltimpulse schalten die zusammenwirkenden Transistoren 58, 59 in den stromleitenden und die ebenfalls zusammenwirkenden Transistoren 61, 62 in den gesperrten Zustand. Dann fliesst Strom vom Speisespannungseingang 67 durch den Schalttransistor 58 über den Anschluss 63 durch die Primärwicklung 64 des Uebertragers 65 zum Anschluss 68 und durch den Schalttransistor 59 zur Gerätemasse 69. Während der Dauer eines nachfolgenden positiven Steuerimpulses auf der in der Figur 3 unteren Leitung zur Primärwicklung 52 des Steuertransformators 51 erscheint an den Ausgängen der Sekundärwicklung 53, 54 ein negativer und an den Ausgängen der Sekundärwicklungen 56, 57 ein positiver Schaltimpuls. Diese Impulse schalten die Transistoren 58, 59 in den nichtleitenden und die Transistoren 61, 62 in den stromleitenden Zustand. Dann fliesst Strom von Speisespannungseingang 67 durch den Transistor 61 über den Anschluss 68 durch die Primärwicklung 64 des Uebertragers 65 zum Anschluss 63 und durch den Transistor 62 zur Gerätemasse 69.

Der während der Dauer der Steuer- bzw. der Schaltimpulse in abwechselnder Richtung durch die Primärwicklung 64 des Uebertragers 65 fliessende Strom induziert in der Sekundärwicklung 76 entsprechende Spannungsstösse, deren zugeordnete Stromstösse in Abhängigkeit von ihrer Polarität vom Brückengleichrichter 77 an den einen oder an den anderer Zweig 78 bzw. 79 der Serieschaltung 26 geleitet wird.

Auch bei dieser Ausführungsform werden die beim Unterbrechen des Stroms in der Primärwicklung entstehenden Spannungsspitzen durch die Dioden 71, 72 bzw. 73, 74, abgeleitet.

Bei dieser Ausführungsform können die in Serie geschalteten und paarweise zusammenwirkenden Schalttransistoren eine gegenüber der Ausführungsform gemäss der Fig. 2 verdoppelte Speisespannung für die Primärwicklung 64 des Uebertragers 65 schalten.

Die beschriebenen Schaltstufen können mit handelsüblichen Bauelementen aufgebaut werden, weshalb auf deren Beschreibung hier ausdrücklich verzichtet wird. Es wird auch angenommen, dass die optimale Auswahl und Dimensionierung der Bauelemente für Schaltstufen mit vorgegebenen Kennwerten im Bereich fachmännischen Könnens liegt und nicht erläutert werden muss.

Es versteht sich, dass die beiden beispielsweise beschriebenen Schaltstufen auf vielerlei Arten abgewandelt, und dass auch anders aufgebaute Schaltstufen verwendet werden können. Beispielsweise ist es möglich, bei der Ausführungsform gemäss der Fig. 2 die Sekundärwicklung 43 des Uebertragers 31 mit einem Brückengleichrichter 77 an die Serieschaltung 26 anzuschliessen und umgekehrt bei der Ausführungsform gemäss der Fig. 3 für die Verbindung zwischen der Sekundärwicklung 76 des Uebertragers 65 und der Serieschaltung 26 eine Zweipulsmittelpunktschaltung zu verwenden. Es versteht sich auch, dass anstelle der beispielsweise gezeigten Steuerimpulsfolgen beliebige andere für den Betrieb eines Schaltverstärkers geeignete Impulsfolgen verwendet werden können, ohne dass dann die beschriebene Arbeitsweise der Schaltstufen geändert wird.

Schliesslich versteht es sich, dass bei den in den Figuren 2 und 3 beispielsweise beschriebenen Schaltstufen die Anschlüsse für die Speisespannung bzw. die Masseleitung vertauscht werden können, wenn geeignete Schalttransistoren und Schutzdioden entsprechend angeschlossen werden.

**Patentanspruch**

Schaltverstärker, enthaltend einen Signalwandler (10), der ein analoges Eingangssignal in mindestens eine Impulsfolge wandelt, und mindestens zwei Schaltstufen (13, 14, 15, 17), von denen jede einen Uebertrager (31 ; 65) aufweist, dessen Primärwicklung (30 ; 64) mittels mindestens zwei steuerbaren Schaltelementen (34, 35 ; 58, 59, 61, 62) mit einer Speisespannungsquelle (36 ; 67) verbindbar ist und dessen Sekundärwicklung (43 ; 76) galvanisch von der Primärwicklung getrennt ist, sowie einen Steuertransformator (37 ; 51) für die Schaltelemente, dessen Primärwicklung (38 ; 52) mit dem Signalwandler (10) und dessen Sekundärwicklungen (39, 40 ; 53, 54, 56, 57) jeweils mit der Steuerelektrode eines zugeordneten Schaltelements verbunden sind, wobei die primärseitigen Speisespannungseingänge der Schaltstufen (13, 14, 15, 17) parallel an die gleiche Speisespannungsquelle (18) angeschlossen und die sekundärseitigen Signalausgänge mittels Gleichrichteranordnungen (21, 22, 23, 24) in Serie geschaltet sind, und weiter ein mit der Serieschaltung verbundenes Tiefpassfilter (27), an dessen freiem Ende das verstärkte Ausgangssignal abnehmbar ist, dadurch gekennzeichnet, dass

— die Primärwicklung (30 ; 64) des Uebertragers (31 ; 65) mit den zugeordneten Schaltelementen (34, 35 ; 58, 59, 61, 62) zu einer Gegentaktschaltung verbunden ist ;

— die Gleichrichterschaltung am Ausgang der Sekundärwicklung (43 ; 76) des Uebertragers (31 ; 65) als Zweiweggleichrichter (46 ; 47 ; 77) ausgebildet ist ;

— die Sekundärwicklungen (39, 40, 53, 54, 56, 57) des Steuertransformators (37 ; 51) für im Gegentakt arbeitende Schaltelemente (34, 35 ; 58, 59, 61, 62) jeweils gegensinnig angeordnet sind ; und

— der Signalwandler (10) ein A/D-Wandler ist, der das analoge Eingangssignal periodisch in eine dem Momentanwert der Amplitude dieses Signals proportionale Anzahl Impulsfolgen mit konstantem Tastverhältnis wandelt und jeder Impulsfolge mindestens eine Schaltstufe zugeordnet ist, so dass die Anzahl der mit den Impulsfolgen angesteuerten Schaltstufen proportional zum Momentanwert der Amplitude des Eingangssignals variiert.

**Claim**

A switching amplifier, containing a signal converter (10), which converts an analog input signal into at least one sequence of pulses, and two or more switching stages (13, 14, 15, 17), each possessing a transformer (31 ; 65), it being possible to connect the primary winding (30 ; 64) of these transformers, by means of two or more controllable switching elements (34, 35 ; 58, 59, 61, 62), to a supply-voltage source (36 ; 67), and their secondary winding (43 ; 76) being separated from the primary winding in a manner such that no conductive connection exists between them, as well as containing a control transformer (37 ; 51) for the switching elements, the primary winding (38 ; 52) of this control transformer being connected to the signal converter (10) and its secondary windings (39, 40 ; 53, 54, 56, 57) being connected to the control electrodes of switching elements which are assigned to these windings, the supply-voltage input terminals of the switching stages (13, 14, 15, 17), on the primary side, being parallel-connected to the same supply-voltage source (18) and the signal-output terminals, on the secondary side, being series-connected by means of rectifier assemblies (21, 22, 23, 24), and further containing a low-pass filter (27), which is connected to the series-connected circuit-assembly, from the free end of which filter the amplified output signal can be picked off, characterized in that

— the primary winding (30 ; 64) of the transformer (31 ; 65) is connected to the switching elements (34, 35 ; 58, 59, 61, 62) which are assigned to it, to form a push-pull circuit arrangement ;

— the rectifier assembly at the output terminal of the secondary winding (43 ; 76) of the transformer (31 ; 65) is designed as a full-wave rectifier (46, 47 ; 77) ;

— the secondary windings (39, 40 ; 53, 54, 56, 57) of the control transformer (37 ; 51) for switching elements (34, 35 ; 58, 59, 61, 62) operating in push-pull mode are in each case arranged in opposition ;

— the signal converter (10) is an analog/digital converter which, at regular time-intervals, converts the analog input signal into a number of pulse-sequences having a constant pulse duty factor, this number being proportional to the instantaneous value of the amplitude of this input signal, and at least one switching stage is assigned to each sequence of pulses, so that the number of switching stages controlled by the pulse-sequences varies in proportion to the instantaneous value of the amplitude of the input signal.

**Revendication**

Amplificateur de commutation contenant un convertisseur de signaux (10), qui convertit un signal d'entrée analogique en au moins une séquence d'impulsions, et au moins deux étages de commutation (13, 14, 15, 17) qui comportent chacun un transformateur (31 ; 65), dont l'enroulement primaire (30 ; 64) peut être connecté à l'aide d'au moins deux éléments de commutation pilotables (34, 35 ; 58, 59, 61, 62) à une source de tension d'alimentation (36 ; 67) et dont l'enroulement secondaire (43 ; 76) est séparé galvaniquement de l'enroulement primaire, ainsi qu'un transformateur de commande (37 ; 51) pour les éléments de commutation, dont l'enroulement primaire (38 ; 52) est connecté au convertisseur de signaux (10) et dont les enroulements secondaires (39, 40 ; 53, 54, 56, 57) sont connectés chaque fois à l'électrode de commande d'un élément de commutation associé, les entrées de tension d'alimentation des étages de commutation (13, 14, 15, 17) situés du côté primaire étant connectées en parallèle à la même source de tension d'alimentation (18) et les sorties de signaux du côté secondaire étant connectées en série au moyen de dispositifs redresseurs (21, 22, 23, 24), et, en outre, un filtre passe-bas (27) connecté au montage en série, de l'extrémité libre duquel peut être obtenu le signal de sortie amplifié, caractérisé en ce que :

— l'enroulement primaire (30 ; 64) du transformateur (31 ; 65) est connecté aux éléments de commutation associés (34, 35 ; 58, 59, 61, 62) en un montage push-pull ;

— le circuit redresseur à la sortie de l'enroulement secondaire (43 ; 76) du transformateur (31 ; 65) a la forme d'un redresseur biphasé (46, 47 ; 77) ;

— les enroulements secondaires (39, 40 ; 53, 54, 56, 57) du transformateur de commande (37 ; 51) pour les éléments de commutation travaillant en push-pull (34, 35 ; 58, 59, 61, 62) sont chaque fois disposés en sens opposés, et

— le convertisseur de signaux (10) est un convertisseur analogique/numérique qui convertit le signal d'entrée analogique périodiquement en un nombre de séquences d'impulsions à taux d'impulsions constant, proportionnel à la valeur instantanée de l'amplitude de ce signal et à chaque séquence d'impulsions est associé au moins un étage de commutation, de sorte que le nombre des étages de commutation activés par les séquences d'impulsions varie proportionnellement à la valeur instantanée de l'amplitude du signal d'entrée.

Fig.1

Fig. 2

Fig. 3